Europäisches Patentamt

European Patent Office

Office européen des brevets

(11) Veröffentlichungsnummer: **0 515 797 A2**

# EUROPÄISCHE PATENTANMELDUNG

(21) Anmeldenummer: **92105481.3**

(51) Int. Cl.⁵: **H05K 7/00**

(22) Anmeldetag: **30.03.92**

(30) Priorität: **10.04.91 DE 9104384 U**

(43) Veröffentlichungstag der Anmeldung:
**02.12.92 Patentblatt 92/49**

(84) Benannte Vertragsstaaten:
**AT DE FR GB IT**

(71) Anmelder: **SIEMENS AKTIENGESELLSCHAFT**
**Wittelsbacherplatz 2**
**W-8000 München 2(DE)**

(72) Erfinder: **Modschiedler, Kurt**
**Langenbrucker Weg 3**
**W-8524 Neunkirchen(DE)**

(54) **Elektronisches Baugruppensystem.**

(57) Kapselförmige Baugruppen (14,16-23) eines modularen Systems der Leistungselektronik sind jeweils von aneinanderreihbaren Baugruppenträgern (1-6) gehalten. Die berührungssicher ausgebildeten Baugruppenträger (1-6) sind zum einen mit Steckverbindern (30,31,44) für ein Bussystem versehen, zum enderen weist jeder Baugruppenträger (1-6) Stromschienenabschnitte (32-35) auf, wobei durch Verschrauben der Stromschienenabschnitte miteinander leistungsfähige Schienensysteme moduler erstellt werden.

FIG 1

Die Erfindung bezieht sich auf ein elektronisches Baugruppensystem, bei dem kapselförmige Baugruppen an jeweils zugeordneten, berührungssicher ummantelten Baugruppenträgern gehalten und über elektrische Steckkontakte mit diesen kontaktiert sind, wobei die Baugruppen mit ihren Baugruppenträgern modular aneinanderreihbar sind und wobei über weitere elektrische Verbindungsglieder die Baugruppenträger miteinander kontaktierbar sind.

Ein derartiges Baugruppensystem ist für Automatisierungsgeräte aus der europäischen Patentanmeldung 236 711 A3 bekannt. Dabei sind Baugruppenträger für kapselförmige Baugruppen jeweils nebeneinander auf einer Tragschiene montierbar. Die Verbindung der Baugruppenträger zueinander erfolgt über spezielle Steuerleitungen. Bei diesen handelt es sich um Flachbandkabel mit angeschlossenen Steckverbindern. Typisch für dieses System ist es, daß einzelne Baugruppenträger bedarfsweise von der Tragschiene abgenommen werden können, wozu dann auch die jeweiligen Fachbandkabel mit ihren zugehörigen Steckverbindern gelöst werden, ohne daß die benachbarten Baugruppenträger in ihrer räumlichen Lage zu verändern sind.

Ein derartiges System hat sich zwar für Steuerungszwecke im Einsatz bewährt, jedoch ist es für solche Zwecke, bei denen mit relativ großen Strömen im System zu rechnen ist, nicht geeignet, weil Stromführungselemente mit dem dazu erforderlichen Querschnitt, insbesondere Stromschienen, dabei konzeptionell nicht vorgesehen sind.

Aufgabe der Erfindung ist es, ein elektronischer Baugruppensystem der eingangs genannten Art so auszubilden, daß dieses auch für Anwendungen einsetzbar ist, bei denen mit relativ großen Strömen zu rechnen ist, so z.B. bei Stromrichterschaltungen.

Gemäß der Erfindung wird diese Aufgabe dadurch gelöst, daß für den Potentialausgleich und/oder die Stromführung zwischen den Baugruppenträgern in jedem Baugruppenträger Stromschienenabschnitte vorgesehen sind, die aus den Flanken der Baugruppenträger weisende freie Enden haben, daß die Baugruppenträger jeweils korrespondierende Durchführungen für freie Enden benachbarter Baugruppenträger aufweisen und daß Mittel zum kraft- und/ oder formschlüssigen Verbinden der freien Enden der Stromschienenabschnitte mit den benachbarten, durch die jeweiligen Durchführungen erreichbaren Stromschienenabschnitte vorgesehen sind.

Die Erfindung geht dabei von der Erkenntnis aus, daß ein Austausch von vom Aufbau her äußerst zuverlässigen Baugruppenträgern in einem Baugruppensystem der Leistungselektronik relativ selten vorkommt, daß jedoch eine Vergrößerung eines Systems durch seitliches Anreihen von zusätzlichen Baugruppenträgern häufig der Fall ist. Demzufolge wird auf die Möglichkeit eines Entfernes von Baugruppenträgern ohne Einflußnahme auf die benachbarten Baugruppentäger ganz bewußt verzichtet. Eine Aus- und Einhängen einzelner komplexer Baugruppen ist aber selbstverständlich nach wie vor ohne einen Eingriff auf die Baugruppenträgeranordnung möglich.

Eine erste Ausbildung der Erfindung ist dadurch gekennzeichnet, daß als Mittel zum Verbinden Schrauben vorgesehen sind. Derartige Schraubverbindungen ermöglichen eine besonders einfache Fixierung der Stromschienenabschnitte gegeneinander. In diesem Zusammenhang erweist es sich auch als vorteilhaft, daß die freien Enden der Stromschienenabschnitte jeweils gabelförmig ausgebildet sind, sodaß beispielsweise für eine Demontage einer Verbindung die jeweilige Schraube nicht gänzlich entfernt, sondern nur gelöst werden muß.

Auch bei Geräten der Energieelektronik muß man heute davon ausgehen, daß auch ein Datenaustauch zwischen den Baugruppen erfolgt, der dann vorteilhafterweise so geschiet, daß für Signalübertragungszwecke an den Flanken der Baugruppenträger korrespondierende Steckverbinder vorgesehen sind. Mit der gleichen Einschubbewegung, die ein Zusammenführen der Stromschienenabschnitte ermöglicht, wird damit dann auch der jeweilige Signalübertragungsweg durch Kuppeln der Steckverbinder geschlossen.

Ein Ausführungsbeispiel der Erfindung ist in der Zeichnung dargestellt und wird im folgenden näher erläutet.

Dabei zeigen :

FIG 1 eine Aneinanderreihung von Baugruppenträgern,

FIG 2 die Anordnung der Baugruppen und

FIG 3 eine Exposivdarstellung eines Baugruppenträgers.

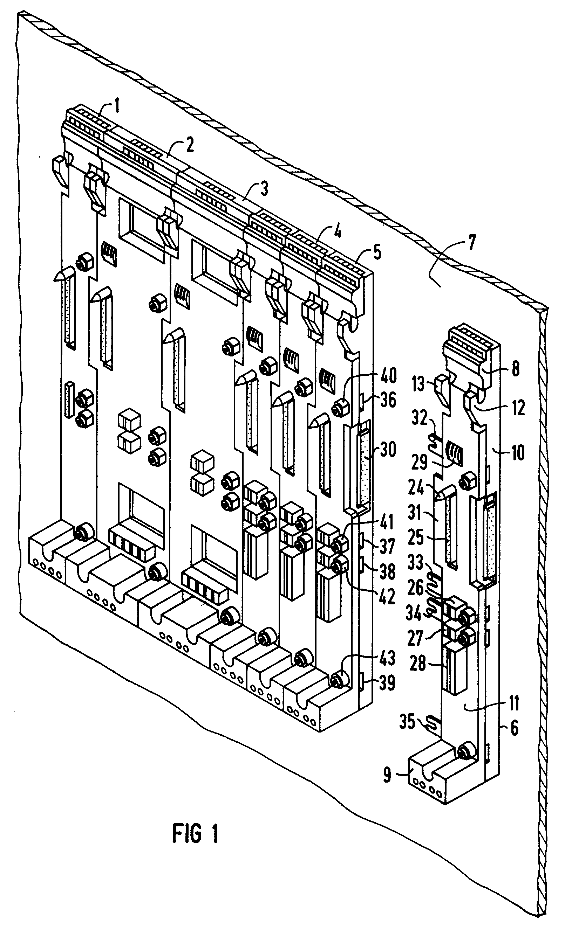

In der Darstellung gemäß FIG 1 ist eine Anordnung von sechs Baugruppenträgern 1 bis 6 an einer Schrankmontagewand 7 gezeigt. Die Baugruppenträger 1 bis 5 sind dabei schon fertig aneinander gereiht, während der Baugruppenträger 6 noch in der durch gestrichelte Linien angedeuteten Art und Weise gegen den Baugruppenträger 5 anzufügen ist. Das Fixieren der Baugruppenträger 1 - 6 an der Schrankmontagewand 7 kann dann beispielsweise mittels Schrauben erfolgen, die in der Darstellung der Übersichlichkeit halber nicht dargestellt sind.

Jeder der Baugruppenträger 1 bis 6 kann an seiner oberen Kante mit Signalklemmen versehen sein, wie dies in der Darstellung an Hand von Signalklemmen 8 am Baugruppenträger 6 gezeigt ist. Am jeweiligen entgegengesetzten Ende jedes Baugruppenträgers 1 bis 6 können Leistungsklemmen 9 vorgesehen sein, wie auch dies für den Baugruppenträger 6 angedeutet ist. Jeder Baugruppenträger, so auch der Baugruppenträger 6, ist zweischalig ausgebildet, wobei er jeweils aus einem Unterteil 10 und einem Oberteil 11 besteht. Die Unterteile und Oberteile, so das Unterteil 10 und das Oberteil 11 bestehen aus isolierendem Kunststoff. Die Unterteile und Oberteile, so das Unterteil 10 und das Oberteil 11, sind durch der Übersichtlichkeit halber im einzelnen nicht dargestellte Verbindungselemente, beispielsweise Schrauben, miteinander verbindbar.

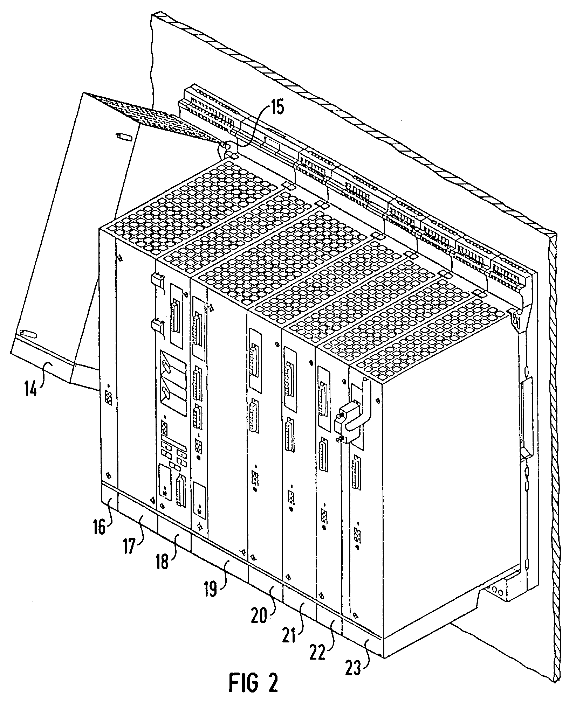

An den Baugruppenträgern 1 bis 6 befinden sich jeweils Kapselgehäuseeinhängungen, so Kapselgehäuseneinhängungen 12 und 13 beim Baugruppenträger 6. In diese Kapselgehäuseeinhängungen werden die jeweils zugehörigen Modulkapseln eingeschwenkt, wie dies in der Darstellung gemäß FIG 2 beispielhaft für eine Modulkapsel 14 gezeigt ist. In dieser Darstellung ist dabei auch die jeweils stiftartige Kapseleinhängung 15 zu sehen, die in die jeweils korrespondierende Kapselgehäuseeinhängung eingesetzt werden kann. Zum endgültigen Einbau würde die Modulkapsel 14 von der gezeigten schrägen Position in eine senkrechte Position verschwenkt werden, so daß eine Stellung erreicht ist, wie sie für weitere Modulkapseln 16 bis 23 gezeigt ist. Die Modulkapseln, so die Kapseln 14 und 16 bis 23, werden dabei jeweils durch Fangbolzen zentriert, von denen in der Darstellung gemäß FIG 1 ein Fangbolzen 24 für den Baugruppenträger 6 bezeichnet ist. Nach dem Zentrieren greifen zum einen Steckverbinder und zum anderen Leistungskontakte ineinander, welche die jeweilige Modulkapsel mit dem jeweils zugeordneten Baugruppenträger verbinden. In der Darstellung gemäß FIG 1 ist als Element zum Verbinden der Signalleitung zwischen dem Baugruppenträger 6 und seiner zugeordneten Modulkapsel ein Busverbindungsstecker 25 gezeigt, für die Leistungsübertragung dienen Leistungskontakte 26 bis 28. Ferner kann für Schirmzwecke ein gefächerter Schirmkontakt 29 am jeweiligen Baugruppenträger angeordnet sein.

Die Weiterleitung der Busverbindung zwischen den einzelnen Baugruppenträgern 1 bis 6 erfolgt durch Steckverbindern, die an den seitlichen Flanken der Baugruppenträger 1 bis 6 vorgesehen sind. Von diesen Steckverbindern ist beispielsweise der Steckverbinder 30 der Baugruppen 5 sichtbar, der mit einem Steckverbinder 31 (in der Darstellung verdeckt) des Baugruppenträgers 6 korrespondieren würde. Für Stromführungszwecke und Potentialausgleich sind Schienen vorgesehen, die sich dadurch ergeben, daß einzelne Schienenabschnitte, die im jedem der Baugruppenträger 1 bis 6 vorgesehen sind, miteinander in Reihe geschaltet werden.

Für den Baugruppenträger 6 handelt es sich dabei um Stromschienenabschnitte 32 bis 35. Diese sind jeweils so ausgebildet, daß sie freie gabelförmige Enden aufweisen, die aus dem jeweiligen Baugruppenträger, z.B. dem Baugruppenträger 6, herausragen und in korrespondierende Ausnehmungen des jeweils benachbarten Baugruppenträgers, in diesem Fall des Baugruppenträgers 5, eingeschoben werden können. Die Ausschnitte sind dabei mit 36 bis 39 bezeichnet. Die Zusammenfügung der Stromschienenabschnitte erfogt im eingeschobenen Zustand mit Hilfe von Schienenverschraubungen von denen in der Zeichnung die Schienenverschraubungen 40 bis 43 für den Baugruppenträger 5 bezeichnet sind. Dabei sei darauf hingewiesen, daß beim Ausführungsbeispiel die unter anderem aus dem Stromschienenabschnitt 35 gebildete Stromschiene als PE-Schiene dient, die aus unter anderem den Stromschieneabschnitten 33 und 43 gebildeten Stromschienen die Zwischenkreisverschienung bewirken und die unter anderem aus dem Stromschienenabschnitt 32 gebildete Stromschiene als Schirmschiene dient.

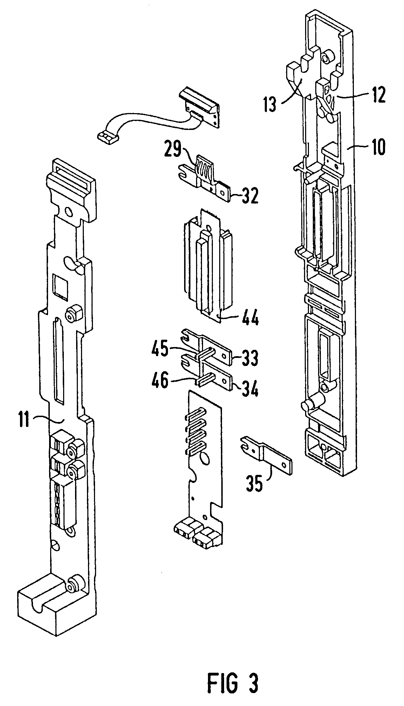

In der Darstellung gemäß FIG 3 ist eine Explosivdarstellung des Baugruppenträgers 6 gezeigt, wobei die gleichen Elemente wie in der Darstellung gemäß FIG 1 und 2 mit eben den gleichen Bezugszeichen versehen sind. Im wesentlichen ist der Darstellung gemäß FIG 3 zu entnehmen, wie die Stromschienenabschnitte 32 bis 35 ausgeformt sind. Es ist ersichtlich, daß es sich jeweil um bandförmige Formteile handelt, die mit einem Schirmkontakt für die Schirmschiene beziehungsweise Hochstromkontakten 45 und 46 für die Zwischenkreisschienen versehen sind. Der Darstellung ist auch entnehmbar, daß die Steckverbinder für die Signalübertragung zu einem gemeinsamen Block in Form einer Busbaugruppe 44 zusammengeführt sein können.

**Patentansprüche**

1. Elektronisches Baugruppensystem, bei dem kapselförmige Baugruppen an jeweils zugeordneten, berührungssicher ummantelten Baugruppenträgern gehalten und über elektrische Steckkontakte mit diesen kontaktiert sind, wobei die Baugruppen mit ihren Baugruppenträgern modular aneinanderreihbar sind und wobei über weitere elektrische Verbindungsglieder die Baugruppenträger miteinander kontaktierbar sind, **dadurch gekennzeichnet,** daß für den Potentialausgleich und/oder die Stromführung zwischen den Baugruppenträgern (1 bis 6) in jedem Baugruppenträger (1 bis 6) Stromschienenabschnitte (32 bis 35) vorgesehen sind, die aus den Flanken der Baugruppenträger (1 bis 6) weisende freie Enden haben, daß die Baugruppenträger (1 bis 6) jeweils korrespondierende Durchführungen für freie Enden benachbarter Baugruppenträger (1 bis 6) aufweisen und daß Mittel (40 bis 43) zum kraft- und/oder formschlüssigen Verbinden der freien Enden der Stromschienenabschnitte (32 bis 35) mit den benachbarten, durch die jeweiligen Durchführungen erreichbaren Stromschienenabschnitte (32 bis 35) vorgesehen sind.

2. Baugruppensystem nach Anspruch 1, **dadurch gekennzeichnet,** daß als Mittel zum Verbinden Schrauben (40 bis 43) vorgesehen sind.

3. Baugruppensystem nach Anspruch 2, **dadurch gekennzeichnet,** daß die freien Enden der Stromschienenabschnitte jeweils gabelförmig ausgebildet sind.

4. Baugruppensystem nach einem der vorstehenden Ansprüche, **dadurch gekennzeichnet,** daß für Signalübertragungszwecke an den Flanken der Baugruppenträger korrespondierende Steckverbinder (30,31) vorgesehen sind.

FIG 1

FIG 2

FIG 3